(19) **Europäisches Patentamt**

**European Patent Office**

**Office européen des brevets**

(11) **EP 0 868 030 B1**

(12) **FASCICULE DE BREVET EUROPEEN**

(45) Date de publication et mention
de la délivrance du brevet:
**14.05.2003 Bulletin 2003/20**

(51) Int Cl.⁷: **H03L 7/113**

(21) Numéro de dépôt: **98410031.3**

(22) Date de dépôt: **24.03.1998**

(54) **Boucle à verrouillage de phase avec circuit d'assistance au verrouillage**

Phasenregelkreis mit Phasenregelhilfsschaltung

Phase-locked loop with phase lock assistance circuit

(84) Etats contractants désignés:
**DE FR GB IT**

(30) Priorité: **25.03.1997 FR 9703907**

(43) Date de publication de la demande:
**30.09.1998 Bulletin 1998/40**

(73) Titulaire: **STMicroelectronics S.A.**
**92120 Montrouge (FR)**

(72) Inventeur: **Dufossez, Vincent**
**38000 Grenoble (FR)**

(74) Mandataire: **de Beaumont, Michel**
**1, rue Champollion**
**38000 Grenoble (FR)**

(56) Documents cités:
**US-A- 4 580 107**

- **PATENT ABSTRACTS OF JAPAN vol. 002, no. 102 (E-052), 23 août 1978 & JP 53 068553 A (MITSUBISHI ELECTRIC CORP), 19 juin 1978,**
- **PATENT ABSTRACTS OF JAPAN vol. 007, no. 251 (E-209), 8 novembre 1983 & JP 58 137308 A (NIPPON DENKI KK), 15 août 1983,**
- **HALLMARK J ET AL: "FM PLL DEMODULATOR WITH LOOP BANDWIDTH CONTROLLED BY TRANSISTOR MATCHING" MOTOROLA TECHNICAL DEVELOPMENTS, vol. 8, no. 1, octobre 1988, pages 67-69, XP000008162**

## Description

La présente invention concerne une boucle à verrouillage de phase utilisée dans un démodulateur de fréquence, et plus particulièrement une telle boucle prévue pour se verrouiller sur une fréquence de porteuse qui peut varier dans une grande plage.

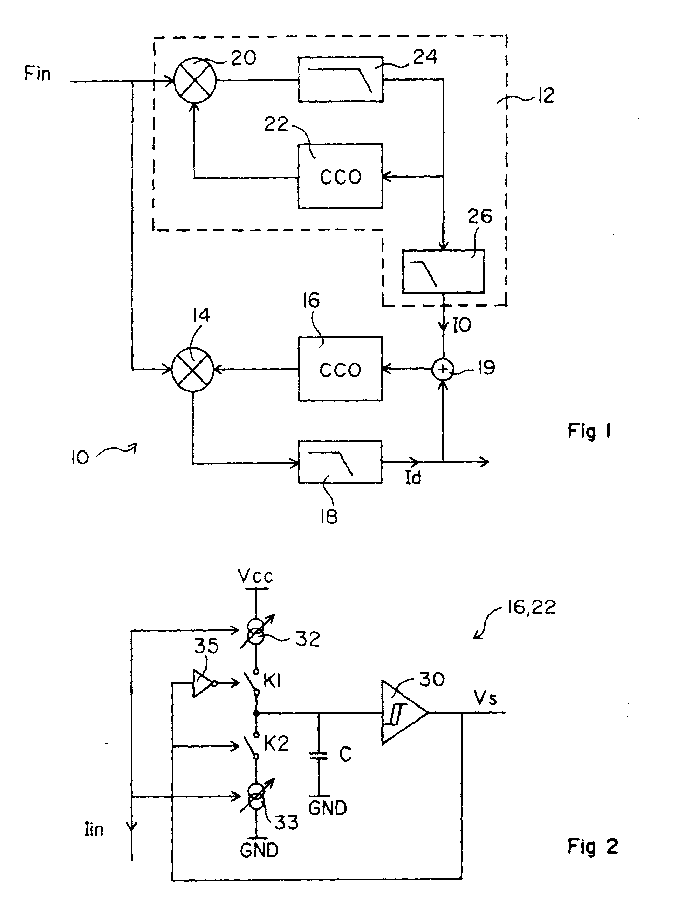

La figure 1 représente schématiquement une boucle à verrouillage de phase classique capable de se verrouiller sur une fréquence de porteuse susceptible de varier dans une grande plage. Cette boucle à verrouillage de phase comprend une boucle à verrouillage de phase principale 10 et un circuit d'assistance au verrouillage 12 qui est classiquement constitué d'une boucle à verrouillage de phase auxiliaire.

La boucle à verrouillage de phase principale 10 comprend un multiplieur 14 recevant le signal d'entrée Fin et la sortie d'un oscillateur commandé (en tension ou en courant) 16. La sortie du multiplieur 14 commande l'oscillateur 16 par l'intermédiaire d'un filtre passe-bas 18 destiné à supprimer la fréquence de porteuse et à laisser passer les fréquences modulées. La sortie du filtre 18 constitue le signal de sortie démodulé Id.

Le circuit d'assistance au verrouillage 12 est prévu pour fournir un signal de préréglage continu I0 qu'un sommateur 19 superpose au signal démodulé Id pour régler la fréquence de repos de l'oscillateur 16 à la fréquence de porteuse du signal Fin.

La boucle à verrouillage de phase auxiliaire du circuit d'assistance 12 comprend un multiplieur 20 recevant le signal d'entrée Fin et la sortie d'un oscillateur commandé (en courant ou en tension) 22. La sortie du multiplieur 20 est fournie à l'entrée de commande de l'oscillateur 22 par l'intermédiaire d'un filtre passe-bas 24 dont la bande passante, nettement supérieure à celle du filtre 18, est adaptée à la plage de variation de la fréquence de porteuse du signal Fin.

La sortie du filtre 24 constitue le signal I0 de préréglage de la fréquence de repos de l'oscillateur 16 après un nouveau filtrage par un filtre passe-bas 26. La bande passante du filtre 26 est telle que le signal I0 soit continu et corresponde à la moyenne du signal de sortie du filtre 24. En tout cas, la bande passante du filtre 26 est inférieure à la plus basse fréquence du signal démodulé Id.

La figure 2 représente schématiquement un oscillateur commandé en courant classique, pouvant être utilisé pour les oscillateurs 16 et 22. Cet oscillateur comprend un condensateur C dont une borne est reliée à un potentiel fixe, tel que la masse GND. L'autre borne du condensateur C est reliée à l'entrée d'un trigger de Schmitt ou comparateur à hystérésis 30, à une source de courant de charge 32 par un interrupteur K1, et à une source de courant de décharge 33 par un interrupteur K2. Les sources de courant 32 et 33 sont par ailleurs reliées, respectivement, à un potentiel d'alimentation haut Vcc et à la masse GND.

La sortie Vs du comparateur à hystérésis 30 commande directement l'interrupteur K2 et commande l'interrupteur K1 par l'intermédiaire d'un inverseur 35.

Le courant des sources 32 et 33 est déterminé par un courant Iin. En fait, les sources 32 et 33 sont constituées par des branches de sortie de miroirs de courant dont les branches d'entrée reçoivent le courant Iin.

En fonctionnement, lorsque la sortie Vs est à zéro, l'interrupteur K1 est fermé et le condensateur C se charge par la source 32. Lorsque le seuil haut du comparateur à hystérésis 30 est atteint, la sortie Vs bascule. Alors, l'interrupteur K1 s'ouvre tandis que l'interrupteur K2 se ferme en provoquant la décharge du condensateur C par la source 33. Si le courant des sources 32 et 33 varie, les temps de charge et de décharge du condensateur, et donc la fréquence du signal de sortie Vs, varient également.

Dans le circuit de la figure 1, le signal de préréglage I0 est la composante continue du signal de commande de l'oscillateur 22, et constitue donc la valeur qui règle la fréquence de repos de l'oscillateur 22 à la fréquence de porteuse du signal Fin. En principe, si les oscillateurs 16 et 22 sont appariés et fonctionnent dans les mêmes conditions, le signal I0 règle également la fréquence de repos de l'oscillateur 16 à la fréquence de porteuse du signal Fin.

L'appariement n'est pas difficile à obtenir en technologie intégrée. Toutefois, l'oscillateur 22 ne fonctionnera jamais dans les mêmes conditions que l'oscillateur 16. En effet, le signal de commande de l'oscillateur 22 présente d'importantes variations de fréquence, dues à la bande passante élevée du filtre 24, tandis que le signal de commande de l'oscillateur 16 varie lentement. Il en résulte que le signal de préréglage I0 n'est pas exactement celui qu'il faut appliquer à l'oscillateur 16 pour régler sa fréquence de repos à la fréquence de porteuse du signal Fin.

Cette erreur du signal de préréglage IO peut provoquer des pertes de verrouillage de la boucle 10, ce qui entraîne un risque de capture de mauvaises fréquences sous la forme qFin présentes dans la bande passante du filtre 24 (q étant un quotient de deux nombres entiers).

Par ailleurs, la boucle à verrouillage de phase 10 tente de compenser cette erreur du signal I0 en produisant une composante continue qui se superpose au signal de sortie Id. Cette composante continue doit généralement être supprimée en aval et diminue la dynamique du signal de sortie.

Un objet de la présente invention est de prévoir une boucle à verrouillage de phase comprenant un circuit d'assistance au verrouillage fournissant un signal de préréglage particulièrement précis.

Cet objet est atteint grâce à une boucle à verrouillage de phase du type comprenant un circuit d'assistance au verrouillage fournissant un signal de préréglage continu représentatif de la fréquence de porteuse d'un signal d'entrée pour fixer la fréquence au repos d'un oscillateur commandé de la boucle à verrouillage de phase. Le circuit d'assistance comprend une bascule monostable cadencée par le signal d'entrée pour fournir des impulsions de largeur prédéterminée, le signal de préréglage correspondant à la moyenne desdites impulsions.

Selon un mode de réalisation de la présente invention, la boucle à verrouillage de phase comprend des moyens pour régler l'amplitude des impulsions proportionnellement au signal de préréglage et pour régler la largeur des impulsions inversement proportionnellement au signal de préréglage.

Selon un mode de réalisation de la présente invention, la boucle à verrouillage de phase comprend un premier et un deuxième miroir de courant, une première branche de sortie du premier miroir étant couplée à la branche d'entrée du deuxième miroir par un interrupteur commandé par le signal de sortie de la bascule monostable, une branche de sortie du deuxième miroir étant couplée à la branche d'entrée du premier miroir par un filtre passe-bas, et des deuxième et troisième branches de sortie du premier miroir fournissant respectivement le signal de préréglage de l'oscillateur commandé et un signal de réglage de largeur d'impulsion à la bascule monostable.

Selon un mode de réalisation de la présente invention, les rapports de recopie des première et troisième branches de sortie du premier miroir sont supérieurs à celui de la deuxième branche de sortie.

Selon un mode de réalisation de la présente invention, la bascule monostable présente essentiellement la même structure que l'oscillateur commandé.

Selon un mode de réalisation de la présente invention, la bascule monostable comprend un condensateur couplé à des sources de courant de charge et de décharge par des interrupteurs respectifs ; un comparateur à hystérésis recevant la tension aux bornes du condensateur ; une porte pour commander l'un des interrupteurs respectifs lorsque le signal d'entrée de la boucle à verrouillage de phase et le signal de sortie du comparateur sont tous deux à l'état haut ; une porte pour commander l'autre des interrupteurs respectifs lorsque le signal d'entrée de la boucle à verrouillage de phase et le signal de sortie du comparateur sont tous deux à l'état bas ; et une porte pour fournir les impulsions de sortie de la bascule monostable lorsque le signal d'entrée de la boucle à verrouillage de phase et le signal de sortie du comparateur sont tous deux à un même état.

Selon un mode de réalisation de la présente invention, la boucle à verrouillage de phase comprend quatre bascules connectées pour, à partir du signal d'entrée de la boucle à verrouillage de phase et du signal de sortie du comparateur, générer quatre signaux qui ne sont jamais tous les quatre à un même état lorsque la fréquence du signal de sortie du comparateur diffère de celle du signal d'entrée de la boucle à verrouillage de phase, et qui prennent tous les quatre un même état lorsque la fréquence du signal de sortie du comparateur est égale à celle du signal d'entrée de la boucle à verrouillage de phase, des moyens étant prévus pour forcer à un état actif la sortie de la bascule monostable lorsque l'état d'au moins un des quatre signaux diffère des autres.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1, précédemment décrite, représente une boucle à verrouillage de phase comportant un circuit d'assistance au verrouillage classique ;

la figure 2 représente un oscillateur commandé en courant classique utilisable dans le circuit de la figure 1 ;

la figure 3 représente un mode de réalisation de circuit d'assistance au verrouillage selon l'invention ;

la figure 4 illustre des signaux présents dans le circuit de la figure 3 ;

la figure 5 représente un mode de réalisation de bascule monostable utilisée dans le circuit de la figure 3 et réalisée à partir d'un oscillateur commandé classique ;

la figure 6 illustre des signaux présents dans le circuit de la figure 5 lors d'un fonctionnement dans des conditions normales ;

la figure 7 illustre des signaux présents dans le circuit de la figure 5 dans une condition de fonctionnement extrême ;

la figure 8 représente un exemple de circuit pouvant être utilisé pour supprimer les dysfonctionnements provoqués par le fonctionnement dans le cas extrême de la figure 7 ; et

la figure 9 illustre des signaux présents dans le circuit de la figure 8 lors d'un fonctionnement dans le cas extrême de la figure 7.

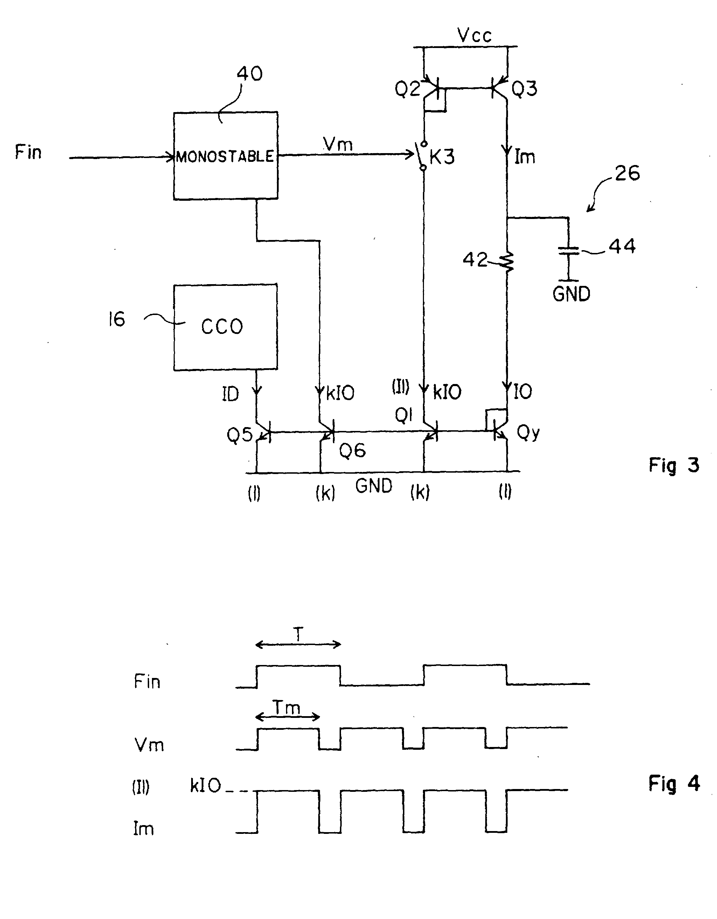

A la figure 3, le circuit d'assistance au verrouillage classique 12 de la figure 1 est remplacé, selon l'invention, par un circuit d'assistance à base d'une bascule monostable 40 cadencée par le signal d'entrée Fin de la boucle à verrouillage de phase. Le signal de sortie logique Vm de la bascule monostable 40 est converti en un courant Im dont la moyenne, obtenue par le filtre 26 déjà présent dans le circuit classique de la figure 1, constitue le courant de préréglage I0 de l'oscillateur 16 commandé en courant.

Plus spécifiquement, le signal logique Vm produit par la bascule monostable 40 commande un interrupteur K3 disposé entre une source de courant Q1 reliée à la masse GND et la branche d'entrée d'un miroir de courant constitué de deux transistors PNP Q2 et Q3. La source de courant Q1 est constituée par un transistor NPN dont l'émetteur est relié à la masse GND et le collecteur est relié à l'interrupteur K3. Les bases des transistors Q2 et Q3 sont reliées l'une à l'autre et leurs émetteurs sont reliés au potentiel d'alimentation haut Vcc. Le collecteur du transistor Q3 fournit le courant Im. Le collecteur et la base du transistor Q2 sont reliés à l'interrupteur K3.

Le collecteur du transistor Q3 est relié, par une résistance 42, à la base et au collecteur d'un transistor NPN Q4 dont l'émetteur est relié à la masse GND. Le transistor Q4 constitue la branche d'entrée d'un miroir de courant. Une branche de sortie de ce miroir est formée d'un transistor NPN Q5 dont la base est reliée à celle du transistor Q4 et dont l'émetteur est relié à la masse GND. Le collecteur du transistor Q5 fournit le courant de préréglage I0 à l'oscillateur 16. Un condensateur 44 est par ailleurs relié entre le collecteur du transistor Q3 et la masse GND. La résistance 42 et le condensateur 44 constituent le filtre passe-bas 26.

Dans un mode de réalisation simplifié du circuit d'assistance au verrouillage selon l'invention, la largeur Tm des impulsions fournies par la bascule monostable 40 est supposée fixe et la source de courant Q1 est supposée indépendante du miroir de courant Q4-Q5, c'est-à-dire que le courant de collecteur du transistor Q1, que l'on désignera par I1 pour l'instant, est indépendant du courant I0.

La figure 4 illustre le signal d'entrée Fin, le signal de sortie Vm correspondant de la bascule monostable 40, et le courant Im. Le signal Fin a une demi-période T. A chaque front du signal Fin, le signal Vm présente une impulsion de largeur Tm, inférieure à la demi-période T. Le courant Im présente la même allure que le signal Vm, sauf qu'il varie entre zéro et le courant I1 fourni par le collecteur du transistor Q1. Le courant I0 est égal à la moyenne du courant Im, et s'exprime par :

$$I0 = I1 \frac{Tm}{T}.$$

La demi-période du signal fourni par l'oscillateur 16 s'exprime par :

$$T_{16} = \frac{C_{16} \Delta V_{16}}{I0}$$

ou encore, en remplaçant I0 par sa valeur,

$$T_{16} = \frac{C_{16} \Delta V_{16}}{I1 \cdot Tm} T,$$

où $C_{16}$ et $\Delta V_{16}$ sont les valeurs respectives du condensateur C et de l'hystérésis du comparateur 30 de l'oscillateur 16.

Ainsi, pour que la fréquence de repos de l'oscillateur 16 soit égale à la fréquence de porteuse du signal Fin, on doit avoir $T_{16}$ = T, c'est-à-dire qu'il faut régler les divers paramètres du circuit pour obtenir $C_{16} \Delta V_{16}$ = I1·Tm.

Les éléments non encore décrits de la figure 3 permettent d'obtenir un réglage automatique de paramètres pour obtenir T = $T_{16}$.

Plus spécifiquement, le transistor Q1 constitue une deuxième branche de sortie du miroir Q4-Q5, c'est-à-dire que la base du transistor Q1 est reliée à la base du transistor Q4. Par ailleurs, la largeur d'impulsion Tm de la bascule monostable 40 est réglée par une troisième branche de sortie du miroir Q4-Q5. Cette troisième branche est constituée d'un transistor NPN Q6 dont la base est reliée aux bases des transistors Q1, Q4 et Q5, dont l'émetteur est relié à la masse GND, et dont le collecteur est relié à une entrée de réglage de largeur d'impulsion de la bascule monostable 40.

Les surfaces d'émetteur normalisées des transistors Q1, Q4, Q5 et Q6 sont indiquées entre parenthèses sous les transistors. Les surfaces normalisées des transistors Q4 et Q5 sont égales à 1, tandis que les surfaces normalisées des transistors Q1 et Q6 sont égales à k, où k est un facteur supérieur à 1. Ainsi, les courants de collecteur des transistors Q4 et Q5 sont égaux à I0, tandis que les courants de collecteur des transistors Q1 et Q6 sont égaux à kIO.

Avec cette configuration, comme cela est indiqué en figure 4, le courant Im présente des impulsions de largeur Tm et d'amplitude kI0. Le courant de préréglage I0, égal à la moyenne du courant Im, s'exprime alors par :

$$I0 = kI0 \frac{Tm}{T} Tm,$$

ce qui veut dire que le système doit tendre vers un état stable où la largeur d'impulsion Tm est telle que T = kTm.

Cette largeur d'impulsion, fournie par la bascule monostable 40 maintenant commandée par le courant kI0, s'exprime par :

$$Tm = \frac{C_{40} \Delta V_{40}}{KI0},$$

où $C_{40} \Delta V_{40}$ est une constante de la bascule monostable 40.

On suppose, par exemple, que la demi-période T augmente. Si la largeur d'impulsion Tm ne varie pas immédiatement, le rapport cyclique du courant Im, et donc la valeur du courant I0, diminuent. Le courant I0 diminuant, le courant de commande kI0 de la bascule monostable 40 diminue également, en provoquant l'augmentation de la largeur d'impulsion Tm et donc du rapport cyclique. Ceci jusqu'à obtenir de nouveau l'équilibre T = kTm.

On s'aperçoit que le système réagit de manière que la surface des impulsions Im soit conservée (la largeur varie inversement proportionnellement à l'amplitude).

En combinant les deux dernières expressions, on obtient :

$$I0 = \frac{C_{40}\Delta V_{40}}{T}.$$

En utilisant cette valeur dans l'expression de la période $T_{16}$ de l'oscillateur 16, qui demeure inchangée en fonction de I0, on obtient :

$$T_{16} = \frac{C_{16}\Delta V_{16}}{C_{40}\Delta V_{40}} \, T.$$

Afin d'obtenir $T_{16} = T$, il suffit de rendre semblables les structures de la bascule monostable 40 et de l'oscillateur 16 pour qu'elles aient les mêmes constantes $C_{16} = C_{40}$ et $\Delta V_{16} = \Delta V_{40}$.

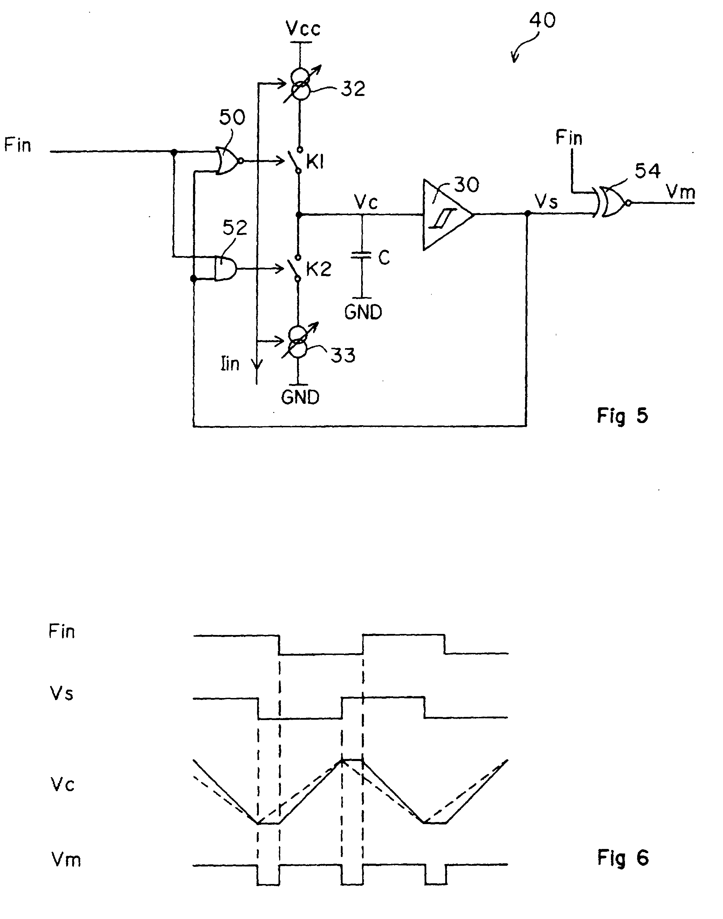

La figure 5 représente schématiquement une bascule monostable obtenue, selon l'invention, à partir de l'oscillateur de la figure 2. Des mêmes éléments dans les figures 2 et 5 sont désignés par des mêmes références. Le circuit de la figure 5 diffère de celui de la figure 2 par la commande des interrupteurs K1 et K2 et par un traitement de la sortie Vs du comparateur à hystérésis 30.

L'interrupteur K1 de charge du condensateur C est fermé lorsque les signaux Fin et Vs sont tous deux à un premier état logique, par exemple 0, tandis que l'interrupteur K2 de décharge du condensateur C est fermé lorsque les signaux Fin et Vs sont tous deux à un deuxième état, par exemple 1. Comme cela est représenté à titre d'exemple, l'interrupteur K1 est commandé par une porte NON OU 50 recevant les signaux Fin et Vs, tandis que l'interrupteur K2 est commandé par une porte ET 52 recevant les signaux Fin et Vs.

Le signal de sortie logique Vm de la bascule monostable est fourni par une porte OU-Exclusif 54 recevant le signal Vs et le signal Fin.

Tous les éléments essentiels de ce circuit peuvent facilement être appariés aux éléments correspondants de l'oscillateur 16, notamment le condensateur C, le comparateur à hystérésis 30, ainsi que les autres éléments qui pourraient intervenir dans les constantes de temps, comme les sources de courant 32, 33 et les interrupteurs K1, K2.

Le choix du facteur k importe peu, pourvu qu'il soit supérieur à un mais suffisamment proche de un pour que la bascule monostable 40 et l'oscillateur 16 fonctionnent dans les mêmes conditions. En effet, le facteur k détermine la différence de pente de charge et de décharge entre le condensateur C de la bascule monostable et le condensateur C de l'oscillateur. Un facteur k d'environ 1,15 fournit de bons résultats.

La figure 6 représente un exemple d'allure de divers signaux pour illustrer le fonctionnement du circuit de la figure 5. La figure 6 représente notamment le signal d'entrée Fin de la boucle à verrouillage de phase, le signal Vs en sortie du comparateur à hystérésis 30, un signal Vc représentant les variations de tension aux bornes du condensateur C, et le signal Vm en sortie de la porte OU-Exclusif 54 et correspondant au signal de sortie de la bascule monostable.

Le signal Fin présente un rapport cyclique de 50 %. Initialement, le signal Fin et le signal Vs sont à 1, d'où il résulte que l'interrupteur K2 est fermé et le signal Vm est à 1. Le condensateur C se décharge jusqu'au seuil bas du comparateur à hystérésis 30. Quand ce seuil bas est atteint, le signal Vs bascule à 0 tandis que le signal Fin est encore à 1. L'interrupteur K2 est ouvert et la charge du condensateur C reste constante, puisque l'interrupteur K1 est également ouvert. Le signal Vm passe à 0.

Lorsque le signal Fin passe à 0, le signal Vs est toujours à 0, ce qui provoque la fermeture de l'interrupteur K1 et le basculement du signal Vm vers l'état haut. Le condensateur C se charge jusqu'au seuil haut du comparateur à hystérésis 30, où le signal Vs bascule de nouveau vers 1 alors que le signal Fin est encore à 0. Les interrupteurs K1 et K2 sont tous deux ouverts, la charge du condensateur C reste constante, et le signal Vm bascule à 0.

Lorsque le signal Fin bascule de nouveau à 1, on retrouve les conditions initiales.

En superposition sur le signal Vc, on a représenté en pointillés l'allure de la tension aux bornes du condensateur C de l'oscillateur 16 fonctionnant dans les mêmes conditions. Cette tension est triangulaire, les sommets correspondant aux fronts du signal Vs produit par l'oscillateur.

Bien entendu, le signal produit par l'oscillateur 16 et celui produit par la bascule monostable 40 ne sont pas forcément en phase, mais ils ont la même fréquence.

Pour des variations lentes de la fréquence du signal Fin, le circuit de la figure 3 s'ajuste automatiquement de manière que le rapport cyclique du signal Vm soit toujours égal à 1/k (T = kTm). Toutefois, lors d'une variation brusque de la fréquence du signal Fin, par exemple à la mise sous tension, il peut survenir une phase transitoire où le courant kI0 est trop faible pour que la tension aux bornes du condensateur C passe d'un seuil du comparateur à hystérésis 30 à l'autre en une demi-période du signal Fin.

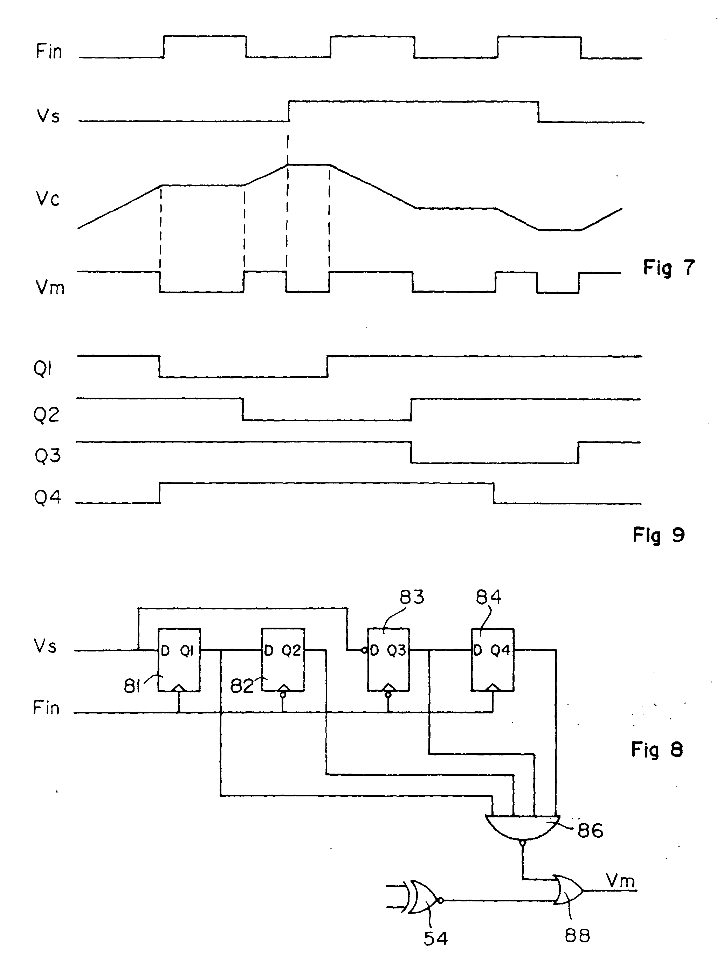

La figure 7 illustre les mêmes signaux que la figure 6 dans ce cas.

Initialement, les signaux Fin et Vs sont à 0. Le condensateur C se charge mais n'atteint pas le seuil supérieur du comparateur à hystérésis 30 au moment où le signal Fin passe à 1. Il en résulte toutefois que l'interrupteur K1 est ouvert et que le condensateur C arrête de se charger. Le signal Vs ne bascule pas. Lorsque le signal Fin passe à 0 de nouveau, le signal Vs est toujours à 0, ce qui provoque une nouvelle charge du condensateur C. Cette fois-ci, le condensateur C se charge jusqu'au seuil supérieur du comparateur, où le signal Vs passe à 1 alors que le signal Fin est toujours à 0. Le condensateur arrête de se charger. Lorsque le signal Fin passe de nouveau à 1, le signal Vs est toujours à 1, ce qui provoque la décharge du condensateur C. Toutefois, lorsque le signal Fin passe de nouveau à 0, le condensateur C n'aura pas eu le temps de se décharger jusqu'au seuil bas du comparateur. Le condensateur arrête de se décharger tandis que le signal Vs reste à 1. Le condensateur recommence à se décharger au moment où le signal Fin passe à 1 alors que le signal Vs est toujours à 1. Le condensateur se décharge jusqu'au seuil bas du comparateur avant le prochain front descendant du signal Fin. Le signal Vs passe alors à 0 et la décharge du condensateur s'arrête. Au prochain front descendant du signal Fin, le cycle précédent est répété.

Comme cela est représenté, le signal Vm présente une allure quelconque qui n'est pas le signal continûment à 1 attendu. On souhaite, dans ce cas, que le signal Vm soit continûment à 1 pour provoquer la fermeture permanente de l'interrupteur K3. En effet, les miroirs de courant Q2-Q3 et Q4-Q1 constituent alors un amplificateur à réaction positive du fait que le facteur k est plus grand que un. Le courant I0 croît donc jusqu'à ce que la vitesse de charge et de décharge du condensateur de la bascule monostable 40 soit suffisante pour que l'un ou l'autre seuil du comparateur à hystérésis soit atteint à l'intérieur d'une demi-période du signal Fin. A ce moment, la croissance du courant IO est arrêtée par l'ouverture de l'interrupteur K3.

La figure 8 représente un exemple de circuit permettant de forcer à 1 la sortie Vm de la bascule monostable 40 lorsque le courant I0 est insuffisant pour que le condensateur C se charge ou se décharge à l'intérieur d'une demi-période du signal Fin. Ce circuit comporte quatre bascules de type D désignées par les références 81 à 84. Les bascules 81 et 84 sont cadencées par le signal Fin, tandis que les bascules 82 et 83 sont cadencées par l'inverse du signal Fin. Les bascules 81 et 83 reçoivent sur leurs entrées de données D respectivement le signal Vs et le signal Vs inversé. L'entrée de la bascule 82 reçoit la sortie Q1 de la bascule 81 et l'entrée de la bascule 84 reçoit la sortie Q3 de la bascule 83. Les sorties Q1 à Q4 des bascules sont fournies à une porte NON ET 86. Une porte OU 88 reçoit la sortie de la porte OU-Exclusif 54 de la figure 5 et la sortie de la porte 86 pour fournir le signal Vm de sortie de la bascule monostable.

La figure 9 illustre les signaux de sortie Q1 à Q4 des bascules dans le cas du fonctionnement extrême de la figure 7. Le signal Q1 prend l'état du signal Vs à chaque front montant du signal Fin. Le signal Q3 prend l'inverse de l'état du signal Vs à chaque front descendant du signal Fin. Le signal Q2 prend l'état du signal Q1 à chaque front descendant du signal Fin. Finalement, le signal Q4 prend l'état du signal Q3 à chaque front montant du signal Fin.

On s'aperçoit que, dans le cas du fonctionnement extrême de la figure 7, au moins un des signaux Q1 à Q4 a toujours une valeur différente des trois autres signaux. Dans ce cas, la sortie de la porte 86 est toujours à 1 et force à 1 le signal Vm de sortie de la bascule monostable.

Dans un cas de fonctionnement normal, les signaux Q1 à Q4 sont tous à 1 dès le début de la deuxième période du signal Fin. La sortie de la porte 86 passe alors à zéro, d'où il résulte que le signal Vm est égal au signal de sortie de la porte OU-Exclusif 54.

De nombreuses variantes et modifications de la présente invention apparaîtront à l'homme du métier. La structure d'oscillateur décrite est du type commandé en courant ; on peut bien entendu envisager des oscillateurs commandés en tension. La bascule monostable a été décrite comme réagissant à tous les fronts du signal d'entrée ; on obtiendrait un fonctionnement convenable avec une bascule monostable ne réagissant qu'aux fronts montants (ou descendants).

## Revendications

1.   Boucle à verrouillage de phase du type comprenant un circuit d'assistance au verrouillage (12) fournissant un signal de préréglage continu (I0) représentatif de la fréquence de porteuse d'un signal d'entrée (Fin) pour fixer la fréquence au repos d'un oscillateur commandé (16) de la boucle à verrouillage de phase, **caractérisée en ce que** le circuit d'assistance comprend une bascule monostable (40) cadencée par le signal d'entrée (Fin) pour fournir des impulsions (Im) de largeur prédéterminée (Tm), le signal de préréglage (I0) correspondant à la moyenne desdites impulsions.

2.   Boucle à verrouillage de phase selon la revendication 1, **caractérisée en ce qu'**elle comprend des moyens (Q1, Q6) pour régler l'amplitude des impulsions (Im) proportionnellement au signal de préréglage (I0) et pour régler la largeur des impulsions inversement proportionnellement au signal de préréglage.

3.   Boucle à verrouillage de phase selon la revendication 2, **caractérisée en ce qu'**elle comprend un premier et un deuxième miroir de courant, une première branche de sortie (Q1) du premier miroir étant couplée à la branche d'entrée (Q2) du deuxième miroir par un interrupteur (K3) commandé par le signal de sortie (Vm) de la bascule monostable (40), une branche de sortie (Q3) du deuxième miroir étant couplée à la branche d'entrée (Q4) du premier miroir par un filtre passe-bas (26), et des deuxième (Q5) et troisième (Q6) branches de sortie du premier miroir fournissant respectivement le signal de préréglage de l'oscillateur commandé (16) et un signal de réglage de largeur d'impulsion à la bascule monostable.

**4.** Boucle à verrouillage de phase selon la revendication 3, **caractérisée en ce que** les rapports de recopie des première et troisième branches de sortie (Q1, Q6) du premier miroir sont supérieurs à celui de la deuxième branche de sortie (Q5).

**5.** Boucle à verrouillage de phase selon l'une quelconque des revendications 1 à 4, **caractérisée en ce que** la bascule monostable (40) présente essentiellement la même structure que l'oscillateur commandé (16).

**6.** Boucle à verrouillage de phase selon la revendication 5, **caractérisée en ce que** la bascule monostable (40) comprend :

- un condensateur (C) couplé à des sources de courant de charge et de décharge (32, 33) par des interrupteurs respectifs (K1, K2) ;
- un comparateur à hystérésis (30) recevant la tension (Vc) aux bornes du condensateur ;
- une porte (52) pour commander l'un des interrupteurs respectifs lorsque le signal d'entrée (Fin) de la boucle à verrouillage de phase et le signal de sortie (Vs) du comparateur sont tous deux à l'état haut ;
- une porte (50) pour commander l'autre des interrupteurs respectifs lorsque le signal d'entrée de la boucle à verrouillage de phase et le signal de sortie du comparateur sont tous deux à l'état bas ; et
- une porte (54) pour fournir les impulsions de sortie (Vm) de la bascule monostable lorsque le signal d'entrée de la boucle à verrouillage de phase et le signal de sortie du comparateur sont tous deux à un même état.

**7.** Boucle à verrouillage de phase selon la revendication 5 ou 6, **caractérisée en ce qu'**elle comprend quatre bascules (81-84) connectées pour, à partir du signal d'entrée (Fin) de la boucle à verrouillage de phase et du signal de sortie (Vs) du comparateur, générer quatre signaux (Q1, Q2, Q3, Q4) qui ne sont jamais tous les quatre à un même état lorsque la fréquence du signal de sortie (Vs) du comparateur diffère de celle du signal d'entrée (Fin) de la boucle à verrouillage de phase, et qui prennent tous les quatre un même état lorsque la fréquence du signal de sortie du comparateur est égale à celle du signal d'entrée de la boucle à verrouillage de phase, des moyens (86, 88) étant prévus pour forcer à un état actif la sortie de la bascule monostable lorsque l'état d'au moins un des quatre signaux diffère des autres.

**Claims**

**1.** A phase-locked loop of the type including a locking aid circuit (12) providing a d.c. presetting signal (I0) representative of the carrier frequency of an input signal (Fin) to set the quiescent frequency of a controlled oscillator (16) of the phase-locked loop, **characterized in that** the aid circuit includes a monostable latch (40) clocked by the input signal (Fin) to provide pulses (Im) of predetermined width (Tm), the presetting signal (I0) corresponding to the mean value of these pulses.

**2.** The phase-locked loop of claim 1, **characterized in that** it includes means (Q1, Q6) for setting the amplitude of the pulses (Im) proportionally to the presetting signal (I0) and for setting the width of the pulses in inverse proportion to the presetting signal.

**3.** The phase-locked loop of claim 2, **characterized in that** it includes a first and a second current mirrors, a first output branch (Q1) of the first mirror being coupled to the input branch (Q2) of the second mirror by a switch (K3) controlled by the output signal (Vm) of the monostable latch (40), an output branch (Q3) of the second mirror being coupled to the input branch (Q4) of the first mirror by a low-pass filter (26), and second (Q5) and third (Q6) output branches of the first mirror respectively providing the presetting signal of the controlled oscillator (16) and a pulse width presetting signal to the monostable latch.

**4.** The phase-locked loop of claim 3, **characterized in that** the mirror ratios of the first and third output branches (Q1, Q6) of the first mirror are higher than that of the second output branch (Q5).

**5.** The phase-locked loop of any of claims 1 to 4, **characterized in that** the monostable latch (40) has substantially the same structure as the controlled oscillator (16).

**6.** The phase-locked loop of claim 5, **characterized in that** the monostable latch (40) includes:

- a capacitor (C) coupled with charge and discharge current sources (32, 33) by respective switches (K1, K2);
- a hysteresis comparator (30) receiving the voltage (Vc) across the capacitor;
- a gate (52) for controlling one of the respective switches when the input signal (Fin) of the phase-locked loop and the output signal (Vs) of the comparator are both in the high state;
- a gate (50) for controlling the other one of the respective switches when the input signal of the phase-locked loop and the output signal of the comparator are both in the low state; and

- a gate (54) for providing the output pulses (Vm) of the monostable latch when the input signal of the phase-locked loop and the output signal of the comparator are both in a same state.

7. The phase-locked loop of claim 5 or 6, **characterized in that** it includes four latches (81-84) connected to generate, from the input signal (Fin) of the phase-locked loop and the output signal (Vs) of the comparator, four signals (Q1, Q2, Q3, Q4) which are never all four at the same state when the frequency of the output signal (Vs) of the comparator differs from that of the input signal (Fin) of the phase-locked loop, and which all four take the same state when the frequency of the output signal of the comparator is equal to that of the input signal of the phase-locked loop, means (86, 88) being provided to force to an active state the output of the monostable latch when the state of one at least of the four signals differs from the others.

## Patentansprüche

1. Phasensynchronisierte bzw. phasenverriegelte Schleife vom Typ mit einer Verriegelungs-Hilfsschaltung (12), welche ein die Trägerfrequenz eines Eingangssignals (Fin) wiedergebendes Voreinstell-Gleichstromsignal (I0) bildet zur Fixierung der Ruhefrequenz eines steuerbaren Oszillators (16) der Phasenverriegelungsschleife **dadurch gekennzeichnet, dass** die Hilfsschaltung eine durch das Eingangssignal (Fin) getaktete monostabile Kippschaltung (40) umfasst zur Bildung von Impulsen (Im) vorgegebener Breite (Tm), und dass das Voreinstellsignal (I0) dem Mittel-bzw. Durchschnittswert der genannten Impulse entspricht.

2. Phasenverriegelungsschleife nach Anspruch 1, **dadurch gekennzeichnet, dass** sie Mittel (Q1, Q6) zur Regelung der Amplitude der Impulse (Im) proportional zu dem Voreinstellsignal (I0) und zur Regelung der Breite der Impulse umgekehrt proportional zu dem Voreinstellsignal aufweist.

3. Phasenverriegelungsschleife nach Anspruch 2, **dadurch gekennzeichnet, dass** sie einen ersten und einen zweiten Stromspiegel umfasst, dass ein erster Ausgangszweig (Q1) des ersten Stromspiegels über einen durch das Ausgangssignal (Vm) der monostabilen Kippschaltung (40) gesteuerten Schalter (K3) mit dem Eingangszweig (Q2) des zweiten Stromspiegels gekuppelt ist, dass ein Ausgangszweig (Q3) des zweiten Stromspiegels über ein Tiefpassfilter (26) mit dem Eingangszweig (Q4) des ersten Stromspiegels gekuppelt ist, und dass zweite (Q5) und dritte (Q6) Ausgangszweige des ersten Stromspiegels das Voreinstellsignal für den steuerbaren Oszillator (16) bzw. ein Signal zur Einstellung der Impulsbreite an die monostabile Schaltung liefern.

4. Phasenverriegelungsschaltung nach Anspruch 3, **dadurch gekennzeichnet, dass** die Spiegelungsverhältnisse des ersten und des dritten Ausgangszweigs (Q1,Q6) des ersten Stromspiegels größer als das des zweiten Ausgangszweigs (Q5) sind.

5. Phasenverriegelungsschleife nach einem der Ansprüche 1 bis 4, **dadurch gekennzeichnet, dass** die monostabile Kippschaltung (40) im wesentlichen denselben Aufbau wie der steuerbare Oszillator (16) aufweist.

6. Phasenverriegelungsschleife nach Anspruch 5, **dadurch gekennzeichnet, dass** die monostabile Kippschaltung (40) umfasst:

- einen über entsprechende Schalter (K1,K2) mit Lade- und Entladestromquellen (32, 33) verbundenen Kondensator (C);
- einen Hysterese-Komparator (30), dem die an den Anschlüssen des Kondensators liegende Spannung (Vc) zugeführt wird;
- eine Torschaltung (52) zur Steuerung eines der betreffenden Schalter, wenn das Eingangssignal (Fin) der Phasenverriegelungsschleife und das Ausgangssignal (Vs) des Komparators sich beide im hohen Zustand befinden;
- eine Torschaltung (50) zur Steuerung des jeweils anderen der betreffenden Schalter, wenn das Eingangssignal der Phasenverriegelungsschleife und das Ausgangssignal des Komparators beide den niedrigen Zustand aufweisen; sowie
- eine Torschaltung (54) zur Lieferung der Ausgangsimpulse (Vm) der monostabilen Kippschaltung, wenn das Eingangssignal der Phasenverriegelungsschleife und das Ausgangssignal des Komparators sich beide im gleichen Zustand befinden.

7. Phasenverriegelungsschleife nach Anspruch 5 oder 6, **dadurch gekennzeichnet, dass** sie vier Kippschaltungen (81 - 84) in solcher Schaltverbindung aufweist, dass sie, ausgehend von dem Eingangssignal (Fin) der Phasenverriegelungsschleife und von dem Ausgangssignal (Vs) des Komparators vier Ausgangssignale (Q1,Q2, Q3, Q4) erzeugen, die sich niemals alle vier im gleichen Zustand befinden, wenn die Frequenz des Komparator-Ausgangssignals (Vs) von der Frequenz des Eingangssignals (Fin) der Phasenverriegelungsschleife verschieden ist, und welche alle vier einunddenselben Zustand einnehmen, wenn die Frequenz des Ausgangssignals des Komparators gleich der Frequenz des Eingangssignals der Phasenverriegelungsschleife ist, und dass Mittel (86,88) vorgesehen sind, welche einen aktiven Zustand der monostabilen Kippschaltung erzwingen, wenn der Zustand wenigstens eines der vier Signale sich von den anderen unterscheidet.

Fig 1

Fig 2

Fig 3

Fig 4

Fig 5

Fig 6

Fig 7

Fig 9

Fig 8